(19) Europäisches Patentamt
European Patent Office
Office européen des brevets

(11) EP 4 700 072 A1

(12) **EUROPEAN PATENT APPLICATION**

(43) Date of publication:
**25.02.2026 Bulletin 2026/09**

(21) Application number: **24382925.6**

(22) Date of filing: **22.08.2024**

(51) International Patent Classification (IPC):
***C08J 3/05*** *(2006.01)* ***C08J 5/18*** *(2006.01)*
***C08L 5/08*** *(2006.01)* ***H05K 1/03*** *(2006.01)*

(52) Cooperative Patent Classification (CPC):
(C-Sets available)
**C08L 5/08; C08J 3/05; C08J 5/18; H05K 1/0393;**
C08J 2305/08 (Cont.)

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(71) Applicant: **Ideaded, S.L.**
**08840 Viladecans (ES)**

(72) Inventor: **RASOOL, Muhammad Azam**
**08840 VILADECANS (ES)**

(74) Representative: **Bardehle Pagenberg S.L.**
**Avenida Diagonal 598, 3º, 1ª**
**08021 Barcelona (ES)**

# (54) CHITOSAN-BASED SUBSTRATES FOR FLEXIBLE ELECTRONICS

(57) A chitosan-based substrate for flexible electronics is provided. The chitosan-based substrate comprises chitosan; and a moisture content equal to or less than 4%.

Furthermore, a method for manufacturing the chitosan-based substrate for flexible electronics is provided. The method comprises providing chitosan; adding the chitosan to an acidic solution; depositing the acidic solution comprising the chitosan; heating the acidic solution comprising the chitosan to form the chitosan-based substrate; obtaining the chitosan-based substrate; and heating the chitosan-based substrate until the chitosan-based substrate comprises a moisture content equal to or less than 4%.

In addition, an integrated circuit for a radio frequency identification, RFID, tag is provided. The integrated circuit comprises RFID circuitry, an antenna coupled or connected to the RFID circuity; either a galvanic connection between the RFID circuitry and the antenna or an inductive element to inductively couple the RFID circuitry to the antenna; and a chitosan-based substrate; wherein the RFID circuity, either the galvanic connection or the inductive element, and the antenna are supported by the chitosan-based substrate.

EP 4 700 072 A1

(52) Cooperative Patent Classification (CPC): (Cont.)

C-Sets
**C08L 5/08, C08K 5/053**

## Description

The present disclosure relates to chitosan-based substrates for flexible electronics and methods for manufacturing the chitosan-based substrates. The present disclosure also relates to integrated circuit for a radio frequency identification, RFID, tags comprising such chitosan-based substrates.

## BACKGROUND

Chitosan is a biopolymer derived from chitin that is biodegradable, flexible, and biocompatible. In particular, chitosan is a chitin-partially-deacetylated derivative comprising randomly distributed β-(1→4)-linked D-glucosamine (deacetylated unit) and N-acetyl-D-glucosamine (acetylated unit).

However, chitosan-based substrates (e.g., films) are not used in flexible electronics. The substrates currently used in flexible electronics, such as PET (polyethylene terephthalate), PEN (polyethylene naphthalate) and PI (polyimide), are plastic-based and highly pollutant.

Due to hydrophilic nature of chitosan, resulting chitosan-based substrates are incompatible with flexible electronics. When contacted with water, current chitosan-based substrates can dissolve completely, which render chitosan-based substrates unsuitable for flexible electronics exposed to moisture, water, or bodily fluids, such as in wearable devices, confining its use to controlled environments where presence of water can be strictly managed.

Current chitosan-based substrates exhibit low thermal stability, rendering unsuitable current chitosan-based substrates for flexible electronic devices that must withstand high temperatures during manufacturing processes, such as screen printing. Particularly, chitosan can thermally degrade at high temperatures, making chitosan-based substrates incompatible with standard electronic manufacturing processes. Moreover, the high shrinkage of chitosan-based substrates when heated makes chitosan-based substrates unsuitable for use in standard electronic manufacturing processes for the manufacture of electronic devices.

Furthermore, current chitosan-based substrates may present surface irregularities which result in poor adhesion and performance of electronic components, leading to reduced electrical performance.

In summary, the water solubility and inherent material limitations of chitosan-based substrates make them unsuitable as substrates for electronic devices.

Examples of the present disclosure seek to at least partially reduce one or more of the aforementioned problems.

## SUMMARY

In one aspect, a chitosan-based substrate for flexible electronics is provided. The chitosan-based substrate comprises chitosan with a weight average molecular weight between 1000 kDa and 1700 kDa and a degree of acetylation equal to or less than 10%. The degree of acetylation is the percentage of the number of acetylated units over the total number of units forming the chitosan. Particularly, the chitosan-based substrate comprises a moisture content equal to or less than 4%.

By virtue of this configuration of the chitosan-based substrate, the chitosan-based substrate is temperature resistant and water resistant. Particularly, it has been found that, surprisingly, chitosan-based substrates comprising chitosan with a weight average molecular weight ($M_w$) between 1000 kDa and 1700 kDa and a degree of acetylation equal to or less than 10% withstand high temperatures.

In some examples, the weight average molecular weight may be between 1200 kDa and 1700 kDa, specifically the weight average molecular weight may be about 1500 kDa.

The present disclosure takes advantage that chitosan with a high weight average molecular weight ($M_w$) have longer chains of glucosamine (deacetylated unit) and N-acetylglucosamine (acetylated unit) than chitosan with low or medium weight average molecular weight ($M_w$).

By virtue of the chitosan having high weight average molecular weight (i.e., $M_w \geq 1000\ kDa$), chitosan-based substrates comprising such chitosan do not degrade at a temperature greater than a boiling point of any substance forming the chitosan-based substrate. As a result, the chitosan-based substrate may be used with standard electronic manufacturing processes such as screen printing.

In some examples, the chitosan-based substrate may be heated at a temperature equal to or greater than 150°C.

As aforementioned, the chitosan-based substrate may be heated at a temperature greater than a temperature corresponding to a boiling point of any substance forming the chitosan-based substrate. For example, the substance may be a solvent or acid used for dissolving the chitosan in a solution to be deposited or casted for obtaining a - wet - chitosan-based substrate. The obtained - wet - chitosan-based substrate may comprise chitosan, water, and a residual solvent or acid. Consequently, the obtained - wet - chitosan-based substrate comprises a high moisture content (e.g., a moisture content greater than 20%). As a result, when the - wet - chitosan-based substrate is heated at a temperature equal to or greater than the temperature corresponding to the highest boiling point of a substance forming the - wet - chitosan-based

substrate, a - dry - chitosan-based substrate may be obtained. For example, considering the water has a boiling point of 100°C and the acid has a boiling point of 120°C, the temperature, at which the - wet - chitosan-based substrate may be heated, is greater than the temperature of the boiling point of the acid, i.e., 120°C (which is, in this example, the highest boiling point of any substance forming the - wet - chitosan-based). As a result, at a temperature equal to or greater than 120°C (e.g., 150°C), the acid and water may evaporate, resulting in the - dry - chitosan-based substrate comprising a moisture content equal to or less than 4%.

By virtue of the moisture content of the - dry - chitosan-based substrate, the chitosan-based substrate is water resistant. Water resistance may be understood as the property or characteristic of the chitosan-based substrate to remain in a single piece when the chitosan-based substrate is submerged in water for a period of 24 hours.

According to the present disclosure, the chitosan-based substrate may comprise no other compound to achieve the result of the chitosan-based substrate being water resistant; where the result of the chitosan-based substrate being water resistant is achieved by the moisture content of the chitosan-based substrate comprising the purposefully selected chitosan.

In some examples, the chitosan-based substrate may comprise a moisture content equal to or less than 1%.

Furthermore, according to this aspect, chitosan-based substrates with enhanced thermal stability may be obtained.

In a further aspect, a method is provided for manufacturing a chitosan-based substrate for flexible electronics. The method comprises providing a chitosan with a weight average molecular weight between 1000 kDa and 1700 kDa and a degree of acetylation equal to or less than 10%; adding the chitosan to an acidic solution; depositing or casting the acidic solution comprising the chitosan to form the chitosan-based substrate; obtaining the chitosan-based substrate; and heating the chitosan-based substrate until the chitosan-based substrate comprises a moisture content equal to or less than 4%.

By virtue of purposefully providing chitosan with a weight average molecular weight ($M_w$) between 1000 kDa and 1700 kDa and a degree of acetylation equal to or less than 10%, the obtained - wet - chitosan-based substrate may be heated to high temperatures, i.e., up to a temperature equal to or greater than the temperature corresponding to the highest boiling point of a substance forming the - wet - chitosan-based substrate, up to 200 °C.

Due to the - wet - chitosan-based substrate being able to be heated to high temperatures, substances forming the - wet - chitosan-based substrate may evaporate, resulting in a - dry - chitosan-based substrate with a moisture content that can be decreased down to 4% or less, specifically a moisture content equal to or less than 1%.

In some examples, the - wet - chitosan-based substrate may be heated at a temperature equal to or greater than 150°C to obtain a - dry - chitosan-based substrate where the - dry - chitosan-based substrate comprises a moisture content equal to or less than 4%.

This allows to obtain a chitosan-based substrate that, when submerged in water for 24 hours, remains in a single piece.

Furthermore, the - dry - chitosan-based substrate may withstand high temperatures during manufacturing processes, such as screen printing, due to enhanced thermal stability. As a result, chitosan according to the present disclosure may be used as a substrate for flexible electronics, where the chitosan-based substrate comprises a moisture content equal to or less than 4%, specifically a moisture content equal to or less than 1%.

In some examples, the method for manufacturing a chitosan-based substrate for flexible electronics may comprise, after heating the chitosan-based substrate, delivering a conductive agent composition onto the chitosan-based substrate to form a conductive element configured to: act as an antenna of a radio frequency identification (RFID) tag; or act as a galvanic connection between an RFID circuitry of the RFID tag and the antenna of the RFID tag; or act as an inductive element to inductively couple the RFID circuitry to the antenna of the RFID tag.

In a further aspect, an integrated circuit for a RFID tag, is provided. The integrated circuit comprises RFID circuitry, an antenna coupled or connected to the RFID circuity; either a galvanic connection between the RFID circuitry and the antenna or an inductive element to inductively couple the RFID circuitry to the antenna; and a chitosan-based substrate according to an example of the present disclosure; wherein the RFID circuity, either the galvanic connection or the inductive element, and the antenna are supported by the chitosan-based substrate according to an example of the present disclosure.

RFID tags which comprise a chitosan-based substrate according to an example of the present disclosure may have enhanced biodegradability. As a result, the RFID tag comprising the chitosan-based substrate may have an improved sustainability with a decreased carbon footprint and overcome environmental issues related to plastic waste accumulation on the earth crust and in the marine ambient.

The term "wt%" may be used to refer to a weight percentage of a first component (e.g., chitosan) relative to the total weight of a solution (e.g., acidic solution).

The term "flexible electronics" may be understood as electronic devices built on flexible substrates that retain their functionality when twisted, folded, or stretched.

The recitation of numerical ranges by endpoints includes all numbers subsumed within that range (e.g., 1 to 5

includes 1, 1.5, 2, 2.75, 3, 3.80, 4, and 5).

## BRIEF DESCRIPTION OF THE DRAWINGS

Non-limiting examples of the present disclosure will be described in the following, with reference to the appended drawings, in which:

Figs. 1 and 3 schematically show block diagrams of methods for manufacturing a chitosan-based substrate for flexible electronics according to an example of the present disclosure;

Fig. 2a shows a chitosan-based substrate for flexible electronics according to an example of the present disclosure and fig. 2b shows a prior-art chitosan-based substrate;

Fig. 4 shows a chitosan-based substrate with deposited metal for flexible electronics according to an example of the present disclosure; and

Fig. 5 schematically represents an integrated circuit for a RFID tag comprising a chitosan-based substrate according to an example of the present disclosure.

## DETAILED DESCRIPTION OF EXAMPLES

In the figures, the same reference signs have been used to designate matching elements.

The present disclosure is concerned with examples of chitosan-based substrates for electronics devices, specifically flexible electronic devices, that for being manufactured may need to withstand electronic manufacturing processes at high temperatures (e.g., 150°C).

Fig. 1 schematically show a block diagram of an example method 100 for manufacturing a chitosan-based substrate for electronic devices, specifically for flexible electronics.

In the example of fig. 1, the method 100 for manufacturing the chitosan-based substrate comprises providing chitosan with a weight average molecular weight ($M_w$) between 1000 kDa and 1700 kDa and a degree of acetylation equal to or less than 10% at block 102.

Chitosan is a linear co-polysaccharide which is a chitin-partially-deacetylated derivative. Chitosan comprises randomly distributed D-glucosamine units and N-acetyl-D-glucosamine units linked by β-(1→4)-glycosidic bonds. The glucosamine is the deacetylated unit whereas the N-acetylglucosamine is the acetylated unit.

Chitosan may be represented by formula (I), as follows:

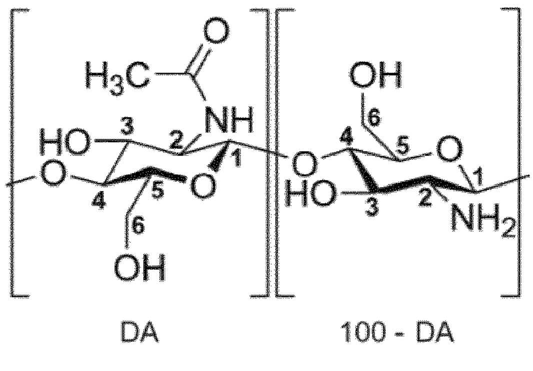

where, in formula (I), DA is the degree of acetylation. The degree of acetylation (DA) may be defined as the percentage of the number of acetylated units, i.e., N-acetylglucosamine units, over the total number of units forming the chitosan, and 100 is the percentage of the total number of units forming the chitosan. Reciprocally, the degree of deacetylation (DD), may be defined as DD = 1 - DA.

Depending on the selection of the degree of acetylation and the weight average molecular weight ($M_w$) of chitosan, physicochemical properties or characteristics of chitosan may be tuned.

It has been found that, surprisingly, chitosan-based substrates comprising chitosan with a weight average molecular weight ($M_w$) between 1000 kDa and 1700 kDa and a degree of acetylation equal to or less than 10% withstand high temperatures (i.e., higher than 100°C).

In some examples, the weight average molecular weight of chitosan may be between 1200 kDa and 1700 kDa, specifically the weight average molecular weight of chitosan may be about 1500 kDa.

As represented by formula (I), chitosan comprises amino functional groups ($-NH_2$). To dissolve chitosan, an acidic solution or acidic medium may be used to protonate the amino functional groups ($-NH_2$), resulting in a net positive charge on the polymer chain and allowing for dissolution of chitosan.

After obtaining the chitosan with the above identified features (i.e., weight average molecular weight $M_w$ and degree of acetylation), the chitosan is solubilized or dissolved by being added in the acidic solution as showed in block 104 of fig. 1.

The acidic solution is an aqueous solution which comprises at least one acid in a solvent. The solvent may be water, specifically distilled water. Particularly, the at least one acid of the acidic solution may be an organic acid, an inorganic acid, or a mixture thereof. The at least one acid may be acetic acid, glacial acetic acid, formic acid, hydrochloric acid, or a mixture thereof.

The concentration of the at least one acid in the acidic solution may be adjusted to avoid or limit acid hydrolysis of the glycosidic bonds. In some examples, a low concentration of the at least one acid may be used. The concentration of chitosan in the acidic solution may be comprised between 1 and 2 wt%, specifically 1.8 wt%.

Furthermore, the pH of the acidic aqueous solution may range from 3.5 to 6.

In some examples, the acidic solution may comprise distilled water as the solvent and glacial acetic acid as the acid. Particularly, the acidic solution may comprise 1.0 wt% (2.0 grams) of glacial acetic acid and 194.0 grams of distilled water. In these examples, 1.8 wt% (3.6 grams) of the chitosan may be added to the acidic solution. For dissolving the chitosan, the acidic solution comprising the chitosan may be magnetically stirred with a magnetic stirrer for a period of 10 hours at a temperature of 40°C.

In some examples, 0.2 wt% (0.4 grams) of glycerol may be added to the acidic solution comprising the chitosan. Glycerol may be used as a plasticizer to improve flexibility of the resulting chitosan-based substrates. As a result, in these examples, the acidic solution may comprise 194.0 grams of distilled water, 1.0 wt% (2.0 grams) of glacial acetic acid, 1.8 wt% (3.6 grams) of chitosan, and 0.2 wt% (0.4 grams) of glycerol, for a total solution weight of 200.0 grams.

The concentration of chitosan (i.e., wt% of chitosan), the pH of the acidic solution, and the temperature at which the chitosan is dissolved may be adjusted depending on the solvents and acids used to form the acidic solution.

After adding the chitosan to the acidic solution, the acidic solution comprising the chitosan is deposited or casted to form the chitosan as showed in block 106 of fig. 1.

The acidic solution comprising the chitosan may be casted against a surface of an element or object, such as a bottom wall of a petri dish.

The casted acidic solution comprising the chitosan, contained for example in the petri dish, may be dried at 50°C in a convection oven for 24 hours. Alternatively or additionally to heating at 50°C the casted acidic solution comprising the chitosan, the casted acidic solution may be dried at room temperature. As a result, chitosan-based substrates are obtained as shown at block 108 of fig. 1. The obtained chitosan-based substrates are - wet - chitosan-based substrates.

The obtained - wet - chitosan-based substrate may comprise chitosan, water, and a residual solvent or acid. Consequently, the obtained - wet - chitosan-based substrate comprises a high moisture content (e.g., a moisture content greater than 20%).

The present disclosure takes advantage that chitosan with a high weight average molecular weight ($M_w$) have longer chains of glucosamine (deacetylated unit) and N-acetylglucosamine (acetylated unit) than chitosan with low or medium weight average molecular weight ($M_w$), e.g., between 50 kDa and 300 kDa.

By virtue of purposefully providing chitosan with a weight average molecular weight ($M_w$) between 1000 kDa and 1700 kDa and a degree of acetylation equal to or less than 10%, the obtained - wet - chitosan-based substrate may be heated to high temperatures, i.e., up to a temperature greater than the temperature corresponding to the highest boiling point of a substance forming the - wet - chitosan-based substrate.

Due to the - wet - chitosan-based substrate being able to be heated to high temperatures (e.g., between 120°C and 200°C), substances forming the - wet - chitosan-based substrate may evaporate, resulting in a - dry - chitosan-based substrate with a moisture content that is equal to or less than 4%, as illustrated at block 110 of fig. 1.

Particularly, the - wet - chitosan-based substrate may be heated at a temperature greater than a temperature corresponding to a boiling point of any substance forming the chitosan-based substrate. The substance may be a solvent or acid used for dissolving the chitosan in a solution to be deposited or casted for obtaining the - wet - chitosan-based substrate.

In table 1, boiling points in °C of example substances that may form the - wet - chitosan-based substrate according to an example of the disclosure, are showed:

**Table 1.**

| Substance | Boiling point (°C) |
|---|---|
| Water | 100 |

(continued)

| Substance | Boiling point (°C) |
|---|---|
| Glacial acetic acid | 118 |

According to the example of table 1, the highest boiling point of a substance forming the - wet - chitosan-based substrate is the boiling point of the glacial acetic acid, namely 118°C. Consequently, in this example, the - wet - chitosan-based substrate may be heated at a temperature greater than the temperature of the boiling point of the glacial acetic acid. As a result, at a temperature greater than 118°C (e.g., 120°C, or 150°C), the glacial acetic acid and water may evaporate, resulting in a - dry - chitosan-based substrate comprising a moisture content equal to or less than 4%.

This allows to obtain a chitosan-based substrate that, when submerged in water for 24 hours, remains in a single piece. Furthermore, heating the chitosan-based substrate until the chitosan-based substrate comprises a moisture content equal to or less than 4% allows crosslinking by heat which results in a chitosan-based substrate with dimensional stability for one-layer processes. As a result, the chitosan-based substrate may be suitable for electronic manufacturing processes.

In some examples, the - wet - chitosan-based substrate may be heated until the - dry - chitosan-based substrate comprises a moisture content equal to or less than 1%.

Heating of the - wet - chitosan-based substrate may be performed with e.g., a convection oven or by using hot pressing.

In the example of hot pressing, additionally to heating the - wet - chitosan-based substrate, the - wet - chitosan-based substrate is submitted to pressure. In some of these examples, the - wet - chitosan-based substrate may be heated under a pressure comprised between 2bar and 3 bar until the - dry - chitosan-based substrate comprises a moisture content equal to or less than 4%, specifically equal to or less than 1%. In some of the examples, the - wet - chitosan-based substrate may be heated at 150°C under a pressure comprised between 2bar and 3 bar for a period of 5 hours.

As a result of hot pressing the - wet - chitosan-based substrate, the obtained - dry - chitosan-based substrate may have enhanced surface roughness (i.e., surface roughness is reduced compared to the surface roughness of - dry - chitosan-based substrates where no pressure is applied during heating.). The obtained - dry - chitosan-based substrate may have a surface roughness below 65 nm, specifically between 35 nm and 60 nm.

As a result of the method 100, the chitosan-based substrate 200 is obtained as showed in fig. 2a.

The chitosan-based substrate 200 is flexible or conformable. The chitosan-based substrate 200 may be flexible or conformable such that the chitosan-based substrate 200 conforms to the contours of an element on which the chitosan-based substrate 200 is arranged or conformable to form a non-planar contact surface against a surface of an element or object. In addition, the chitosan-based substrate 200 manufactured by the method 100 is dimensionally and thermally stable at temperatures up to 200°C, specifically between 100°C and 160°C.

By virtue of the moisture content of the chitosan-based substrate 200 manufactured by the method 100, the chitosan-based substrate 200 is water resistant. Water resistance may be understood as the property or characteristic of the chitosan-based substrate to remain in a single piece when the chitosan-based substrate is submerged in water for a period of 24 hours.

Fig. 2a is a photograph of the chitosan-based substrate 200 manufactured by the method 100 after being submerged in water 202 for 24 hours. As shown in fig. 2a, the chitosan-based substrate 200 manufactured by the method 100 remains in a single piece, therefore, being water resistant.

On the other hand, fig. 2b shows a prior-art chitosan-based substrate 204; where the prior-art chitosan-based substrate 204 has a high moisture content (i.e., 8%) and comprises chitosan with a low weight average molecular weight.

Fig. 2b is a photograph of the prior-art chitosan-based substrate 204 after being submerged in water 202 for 24 hours. As shown in fig. 2b, the prior-art chitosan-based substrate 204 does not remain in a single piece but in a plurality of strands of chitosan 204a - 204d. Consequently, the prior-art chitosan-based substrate 204 is not water resistant.

Fig. 3 schematically show a block diagram of an example method 100 to illustrate features of the present disclosure. Features of fig. 3 may be described in combination with the features of any of the examples shown in fig. 1 and fig. 2a.

Compared to the block diagram shown in fig. 1, the block diagram of the example method 100 shown in fig. 3 further comprise, after heating the chitosan-based substrate at block 110, delivering a conductive agent composition onto the chitosan-based substrate at block 112 of fig. 3.

The conductive agent composition may comprise an electrically conductive compound selected from at least one of the following: e.g., silver; aluminum, carbon; carbon allotropes; copper; and a combination thereof. Particularly, the electrically conductive compound may have one to four valence electrons. In addition, the conductive agent composition may comprise a solid content between 5 and 70 wt% of the total weight of the ink, specifically between 30 and 70wt%.

Delivering the conductive agent composition onto the chitosan-based substrate at block 112 allows to form a conductive element configured to: act as an antenna of an integrated circuit for a radio frequency identification (RFID) tag;

or act as a galvanic connection between an RFID circuitry of the RFID tag and the antenna of the RFID tag; or act as an inductive element to inductively couple the RFID circuitry to the antenna of the RFID tag. Particularly, for delivering the conductive agent composition onto the chitosan-based substrate, sputtering or screen printing may be used.

In some examples, the method 100 may further comprise, after delivering the conductive agent composition at block 112, curing the conductive agent composition. Curing may be performed by heating the conductive agent composition, e.g., in a convection oven.

As a result of delivering the conductive agent composition onto the chitosan-based substrate, chitosan-based substrates onto which metal deposition has been carried out are obtained as shown in fig. 4.

Fig. 4 is a photograph of a chitosan-based substrate with deposited metal manufactured by the method 100 according to an example disclosed in the description of figs. 1 to 3.

Fig. 4 shows a first chitosan-based substrate with deposited metal 300 and a second chitosan-based substrate with deposited metal 302.

In fig. 4, the first and the second chitosan-based substrate with deposited metal 300, 302 are obtained by metal deposition through a mask under vacuum conditions by sputtering (see: metal deposition using the chitosan-based substrate of the example section for the manufacturing of the first and the second chitosan-based substrate with deposited metal 300, 302 of fig.4). The deposited metal on the first chitosan-based substrate with deposited metal 300 is silver (Ag). The deposited metal on the second chitosan-based substrate with deposited metal 302 is titanium (Ti).

In some examples, the deposited metal on the chitosan-based substrate may be aluminum (Al).

Additionally or alternatively to obtaining the first and the second chitosan-based substrate with deposited metal 300, 302, chitosan-based substrates onto which screen printing has been carried out, as shown in fig. 5, may be obtained to form at least one of the following: RFID circuitry, an antenna, a galvanic connection, and an inductive element as a result of delivering the conductive agent composition onto the chitosan-based substrate (as illustrated in fig. 3).

Fig. 5 schematically represents an integrated circuit for a RFID tag comprising a chitosan-based substrate manufactured by the method 100 according to an example disclosed in the description of figs. 1 to 4.

Depending on the design of the RFID tag, an RFID tag with galvanic connection 400 or an RFID tag with inductive coupling 410 may be obtained as shown in fig. 5.

The RFID tag with galvanic connection 400 comprises RFID circuitry 402, an antenna 404 connected to the RFID circuitry 402 through a galvanic connection 406 between the RFID circuitry 402 and the antenna 404.

The RFID tag with inductive coupling 410 comprises RFID circuitry 402, an antenna 404 coupled to the RFID circuitry 402 through an inductive element 412 to inductively couple the RFID circuitry 402 to the antenna 404.

In these examples, i.e., the RFID tag with galvanic connection 400 and the RFID tag with inductive coupling 410, the RFID circuity 402, either the galvanic connection 406 or the inductive element 412, and the antenna 404 are supported by the chitosan-based substrate obtained according to an example disclosed in the description of figs. 1 to 4.

The RFID circuitry 402 may comprise any circuitry commonly found in any conventional (passive or active) RFID tags for enabling RFID functionality (e.g., energy harvesting from signal received via the antenna 404, storing ID data and optionally additional data and performing data processing functions). The RFID circuitry 402 may be at least configured to receive RF energy from a received signal for powering itself, modulate the RF energy and transmit (or reflect) it back. The reflected RF signal may carry modulated data (i.e., data encoded in the form of changes in amplitude, frequency, or phase of the RF signal). The RFID circuitry 402 may comprise one or more individual circuits. The RFID circuitry 402 may comprise analog and / or digital circuitry. For example, the RFID circuitry 402 may comprise one or more passive circuit components such as a resistor, an inductor, and / or a capacitor. Additionally or alternatively, the RFID circuitry 402 may comprise a circuit component such as a transistor, a diode, a memory cell, and / or a logic gate. The RFID circuitry 402 may be configured to implement modulation, demodulation, energy harvesting, digital baseband processing, memory storage, and / or one or more clocks. Individual circuit components may be connected to each other using additional interconnect layers.

EXAMPLE

Below, an example of chitosan-based substrate obtained according to the present disclosure.

<u>Materials:</u>

- Chitosan, CAS number: 9012-76-4, with a high weight average molecular weight $M_w$ = 1500 kDa with a viscosity between 1000 cp and 2000 cp and a degree of acetylation equal to or less than 10%.
- Glycerol, CAS number: 56-81-5.
- Ethyl alcohol, CAS number: 64-17-5.

- Isopropyl alcohol, CAS number: 67-63-0.
- Glacial acetic acid, CAS number: 64-19-7.
- Distilled water, CAS number: 7732-18-5.

Glycerol, ethyl alcohol, isopropyl alcohol, glacial acetic acid are used as purchased.

Chitosan preparation:

Chitosan is dried for 1h at 100 °C in a convection oven before use.

Acidic solution preparation:

- 194.0 grams of distilled water.
- 1.0 wt% (2.0 grams) of glacial acetic acid. The term "glacial acetic acid" may refer to water-free (anhydrous) acetic acid.

Chitosan-based substrate preparation:

1.8 wt% (3.6 grams) of the - dried - chitosan is added to a laboratory flask containing the acidic solution (prepared as described in "acidic solution preparation").

The acidic solution comprising the chitosan is magnetically stirred with a magnetic stirrer IKA C-MAG HS 7 for a period of 10 hours at a temperature of 40°C. The stirring speed is varied from 300 rpm to 100 rpm from the beginning till the end. Particularly, the stirring speed is decreased from 300 rpm to 100 rpm after the first hour of stirring.

After a period of 5 hours of magnetically stirring the acidic solution comprising the chitosan, 0.2 wt% (0.4 grams) of glycerol is added to the acidic solution comprising the chitosan. Glycerol is used as a plasticizer to improve flexibility of the resulting chitosan-based substrates. Addition of glycerol in the acidic solution comprising the chitosan is optional.

As a result, the acidic solution comprises 194.0 grams of distilled water, 1.0 wt% (2.0 grams) of glacial acetic acid, 1.8 wt% (3.6 grams) of chitosan, and 0.2 wt% (0.4 grams) of glycerol, for a total solution weight of 200.0 grams.

After magnetically stirring the acidic solution comprising the chitosan, filtration is carried out using filter paper (i.e., filter paper equivalent to Whatman 4 with pore size between 10 μm and 12 μm) to remove undissolved particles and impurities.

The resulting acidic solution comprising the chitosan is kept at room temperature for degassing to remove air bubbles. Degassing the resulting acidic solution comprising the chitosan is optional.

The resulting acidic solution comprising the chitosan is deposited or casted in petri dishes. The casted acidic solution comprising the chitosan, contained in the petri dishes, is dried at 50 °C in a convection oven for 24 hours. Alternatively, room temperature for drying the casted acidic solution may be used. As a result, chitosan-based substrates are obtained.

After drying, non-solvent (e.g., ethyl alcohol) is added into the petri dishes for the complete removal of solvents. Therefore, the chitosan-based substrates are removed from the petri dishes by peeling the chitosan-based substrates off with the help of a blade.

For cleaning the chitosan-based substrates, isopropyl alcohol is applied onto the chitosan-based substrates to maintain the surface morphology and prevent bending of the chitosan-based substrates.

The obtained chitosan-based substrates are considered to be - wet - chitosan-based substrates because of their high moisture content greater than 20%.

Heating of the chitosan-based substrates prepared as described in "chitosan-based substrate preparation":

The chitosan-based substrates prepared as described in "chitosan-based substrate preparation" are put or sandwiched between two glass plates. The - sandwiched - chitosan-based substrates (by the glass plates) are heated in a convection oven at 150 °C for a period of 5 hours until the chitosan-based substrate comprises a moisture content equal to or less than 4%.

The moisture content may be measured as follows:

$$\textbf{Eq. 1: } Moisture\ content = \left(\frac{wet\ sample - dry\ sample}{wet\ sample}\right).100$$

Where the wet sample is the weight in grams of a sample of the obtained - wet - chitosan-based substrate, the dry sample is the weight of a sample of the obtained - wet - chitosan-based substrate that has been heated where the weight difference is

less than $10^{-3}$ grams during at least 90 min.

The gravimetric method may be used to determine the loss on drying of the - wet - chitosan-based substrate. The weight loss is calculated by drying the sample to a consistent weight and weighing the sample both before and after drying.

In table 2, the weight, the weight difference, moisture content of the - wet - chitosan-based substrate; and heating time according to an example of the disclosure, are showed:

**Table 2.**

| Weight (g) | Weight difference (g) | Moisture content (%) | Heating time at 150°C (min) |
|---|---|---|---|
| 2.184 | | 21.07 | 0 |
| 2.076 | 0.107 | 17.00 | 60 |
| 1.787 | 0.289 | 3.58 | 135 |
| 1.762 | 0.026 | 2.18 | 210 |
| 1.746 | 0.016 | 1.31 | 260 |
| 1.743 | 0.004 | 1.11 | 295 |
| 1.729 | 0.013 | 0.35 | 340 |
| 1.725 | 0.004 | 0.11 | 400 |
| 1.724 | 0.001 | 0.03 | 430 |
| 1.723 | < 0.000 | < 0.00 | 490 |
| 1.723 | < 0.000 | < 0.00 | 520 |

Weight difference is the difference of weight between the former weight of the chitosan-based substrate and the current weight of the chitosan-based substrate. Furthermore, table 2 shows corresponding heating times during which the chitosan-based substrate is heated at a temperature of 150°C.

The measurements and results of table 2 relate to a chitosan-based substrate formed by an acidic solution comprising 194.0 grams of distilled water, 1.0 wt% (2.0 grams) of glacial acetic acid, 1.8 wt% (3.6 grams) of chitosan, and 0.2 wt% (0.4 grams) of glycerol.

For example, after heating the chitosan-based substrate during 135 minutes at a temperature of 150°C, the weight of the sample is 1.787 grams. Similarly, after heating the chitosan-based substrate during 520 minutes at a temperature of 150°C, the weight of the sample is 1.723 grams.

The latter measurement is considered to correspond to the "dry sample" value for calculating the moisture content in eq. 1. A measurement may be considered to correspond to the "dry sample" value if the weight difference is less than $10^{-3}$ grams during at least 90 min. In table 2, < 0.000 means that the weight difference is equal to or less than 0.0009 grams. Consequently, in this example, when the chitosan-based substrate is heated for 520 minutes at a temperature of 150°C, the weight difference is less than $10^{-3}$ grams from the 430$^{th}$ minute of heating. Therefore, the weight of 1.723 grams is considered as the "dry sample" value in this example.

The former measurement is considered to correspond to the "wet sample" value for calculating the moisture content in eq. 1. The "wet sample" value is the current weight of the chitosan-based substrate during heating.

As a result, for the chitosan-based substrate heated during 135 min at a temperature of 150°C, the moisture content is as follows:

$$Moisture\ content = \left(\frac{1.787 - 1.723}{1.787}\right).100 = 3.58\%$$

An analogous calculation may be done for the chitosan-based substrate at each heating time.

Furthermore, linear change in length of the chitosan-based substrates used to obtain the measurements and results of table 2 has been measured.

Linear change in length may be measured as follows:

**Eq. 2:** $$Linear\ change\ in\ length = \frac{l_f - l_i}{l_i}.100$$

Where $l_i$ is the initial length between two points of the chitosan-based substrate and $l_f$ is the final length between the same two points of the chitosan-based substrate after heating.

In table 3, the length between two points of the chitosan-based substrate, the heating time, the moisture content, and the linear change in length, are showed:

**Table 3.**

| Length (cm) | Heating time at 150°C (min) | Moisture content (%) | Linear change in length (%) |
|---|---|---|---|
| 12.80 | 0 | 21.07 | |
| 12.40 | 60 | 17.00 | - 3.13 |
| 12.10 | 135 | 3.58 | - 2.42 |
| 12.10 | 210 | 2.18 | 0.00 |
| 12.00 | 260 | 1.31 | - 0.83 |
| 11.90 | 295 | 1.11 | - 0.83 |
| 11.90 | 340 | 0.35 | 0.00 |
| 11.90 | 400 | 0.11 | 0.00 |
| 11.90 | 430 | 0.03 | 0.00 |
| 11.90 | 490 | < 0.00 | 0.00 |
| 11.90 | 520 | < 0.00 | 0.00 |

As shown in table 3, the chitosan-based substrate shows minimized shrinkage (i.e., minimized linear change in length) because of the low moisture content (i.e., equal to or less than 4%) of the chitosan-based substrate. Because the linear change in length is minimized, the chitosan-based substrate may exhibit a high oxygen barrier.

In these examples, dimensional stability of the chitosan-based substrate is measured according to ASTM D1204, and weight loss of the chitosan-based substrate is measured according to ASTM D471.

<u>Metal deposition using the chitosan-based substrate:</u>

A sputter coater is used to deposit either silver (Ag), or aluminum (Al), or titanium (Ti) through a mask under vacuum conditions of 2-5 $\times 10^{-6}$ mbar onto the chitosan-based substrates obtained in "heating of the chitosan-based substrates prepared".

After deposition of silver (Ag), or aluminum (Al), or titanium (Ti) on the chitosan-based substrates, the resulting chitosan-based substrates are heated at 150 °C for 30 minutes in a convection oven.

The result is chitosan-based substrates onto which metal deposition has been carried out.

<u>RFID tag manufacturing using the chitosan-based substrate:</u>

A semi-automatic stencil printer is used for screen printing onto the chitosan-based substrates obtained in "heating of the chitosan-based substrates".

A polyester screen with a mesh size from 90 $\mu$m to 200 $\mu$m is used. Squeegee shore hardness ranges from 70 to 90. For conductive agent composition, a cupper-based ink LF-360-paste is used.

For delivering the conductive agent composition, sheet-to-sheet (S2S) or roll-to-roll (R2R) process may be used. When S2S is used, hot pressing is performed at a temperature between 150°C and 170°C for a period of 150 seconds. When R2R is used, laminating is performed at a temperature of 170°C for a period of 12 seconds.

After delivering the conductive agent composition either by S2S or by R2R, a conductive element is formed onto the chitosan-based substrates. The conductive element may act as an antenna of an RFID tag; or act as a galvanic connection between an RFID circuitry of the RFID tag and the antenna of the RFID tag; or act as an inductive element to inductively couple the RFID circuitry to the antenna of the RFID tag.

After the conductive element is formed onto the chitosan-based substrates, the chitosan-based substrates (onto which S2S or R2R process has been carried out) are heated at a temperature of 140°C for a period of 2 minutes in a convection oven.

The result is chitosan-based substrates onto which screen printing has been carried out to form at least one of the following: RFID circuitry, an antenna, a galvanic connection, and an inductive element. For a chitosan-based substrate with a thickness of 25 μm, sheet resistivity is between 0.006 Ω/sq/25μm and 0.009 Ω/sq/25μm depending on the used process (i.e., S2S or R2R).

Therefore, chitosan with a weight average molecular weight between 1000 kDa and 1700 kDa and a degree of acetylation equal to or less than 10% may be used to obtain a chitosan-based substrate. Particularly, when the obtained chitosan-based substrate has a moisture content equal to or less than 4%, chitosan and the resulting chitosan-based substrate may be used as a substrate for flexible electronics.

For reasons of completeness, various aspects of the present disclosure are set out in the following numbered clauses:

Clause 1. A chitosan-based film comprising:

chitosan with a degree of acetylation equal to or less than 10%;
wherein the degree of acetylation is the percentage of the number of acetylated units over the total number of units forming the chitosan; and
wherein the chitosan-based film comprises a moisture content equal to or less than 4%.

Clause 2. The chitosan-based film according to clause 1, wherein the acetylated units are N-acetylglucosamine units and the units forming the chitosan comprise N-acetylglucosamine units and glucosamine units.

Clause 3. The chitosan-based film according to clause 1 or clause 2, wherein the weight average molecular weight is between 1000 kDa and 1700 kDa, specifically the weight average molecular weight is between and 1200 kDa and 1700 kDa.

Clause 4. The chitosan-based film according to clause 3, wherein the weight average molecular weight is about 1500 kDa.

Clause 5. The chitosan-based film according to any of clauses 1 to 4, wherein the chitosan-based film comprises a moisture content equal to or less than 1%.

Clause 6. The chitosan-based film according to any of clauses 1 to 5, wherein the chitosan-based film is flexible.

Clause 7. The chitosan-based film according to any of clauses 1 to 6,

wherein the chitosan-based film comprises no other compound to achieve the result of the chitosan-based film being water resistant; and
wherein the result of the chitosan-based film being water resistant is achieved by the moisture content of the chitosan-based film.

Clause 8. Method for manufacturing a chitosan-based film, the method comprising:

providing chitosan with a weight average molecular weight between 1000 kDa and 1700 kDa and a degree of acetylation equal to or less than 10%;
adding the chitosan to an acidic solution;
depositing the acidic solution comprising the chitosan to form the chitosan-based film; and
obtaining the chitosan-based film.

Clause 9. The method according to clause 8,

wherein the degree of acetylation is the percentage of the number of acetylated units over the total number of units

forming the chitosan; and
wherein the acetylated units are N-acetylglucosamine units and the units forming the chitosan comprise N-acetylglucosamine units and glucosamine units.

Clause 10. The method according to clause 8 or clause 9, wherein the weight average molecular weight is between 1200 kDa and 1700 kDa.

Clause 11. The method according to clause 10, wherein the weight average molecular weight is about 1500 kDa.

Clause 12. The method according to any of clauses 8 to 11, the method comprising, after obtaining the chitosan-based film, heating the chitosan-based film until the chitosan-based film comprises a moisture content equal to or less than 4%.

Clause 13. The method according to any of claims 8 to 11, the method comprising, after obtaining the chitosan-based film, heating the chitosan-based film until the chitosan-based film comprises a moisture content equal to or less than 1%.

Clause 14. The method according to clause 12 or clause 13, wherein heating the chitosan-based film comprises heating the chitosan-based film at a temperature greater than a boiling point of any substance forming the acidic solution, specifically the temperature is equal to or greater than 150°C.

Clause 15. The method according to any of clauses 12 to 14, the method comprising, after heating the chitosan-based film, delivering a conductive agent composition onto the chitosan-based film to form a conductive element configured to:

- act as an antenna of an RFID tag; or
- act as a galvanic connection between an RFID circuitry of the RFID tag and the antenna of the RFID tag; or
- act as an inductive element to inductively couple the RFID circuitry to the antenna of the RFID tag.

Clause 16. The method according to clause 15, the method comprising, after delivering the conductive agent composition, curing the conductive agent composition.

Clause 17. Use of chitosan as a substrate for printed electronics, the chitosan with a weight average molecular weight between 1000 kDa and 1700 kDa and a degree of acetylation equal to or less than 10%;

wherein the degree of acetylation is the percentage of the number of acetylated units over the total number of units forming the chitosan; and
wherein the substrate comprises a moisture content equal to or less than 4%, specifically a moisture content equal to or less than 1%.

Clause 18. A chitosan-based substrate for flexible electronics, the chitosan-based substrate comprising:

chitosan with a weight average molecular weight between 1000 kDa and 1700 kDa and a degree of acetylation equal to or less than 10%;
wherein the degree of acetylation is the percentage of the number of acetylated units over the total number of units forming the chitosan; and
wherein the chitosan-based substrate comprises a moisture content equal to or less than 4%.

Clause 19. The chitosan-based substrate according to clause 18, wherein the chitosan-based substrate comprises a moisture content equal to or less than 1%.

Clause 20. The chitosan-based substrate according to clause 18 or clause 19, wherein the acetylated units are N-acetylglucosamine units and the units forming the chitosan comprise N-acetylglucosamine units and glucosamine units.

Clause 21. The chitosan-based substrate according to any of clauses 18 to 20, wherein the weight average molecular weight is between 1200 kDa and 1700 kDa.

Clause 22. The chitosan-based substrate according to clause 21, wherein the weight average molecular weight is about 1500 kDa.

Clause 23. Method for manufacturing a chitosan-based substrate for flexible electronics, the method comprising:

providing chitosan with a weight average molecular weight between 1000 kDa and 1700 kDa and a degree of acetylation equal to or less than 10%;
adding the chitosan to an acidic solution;
depositing the acidic solution comprising the chitosan to form the chitosan-based substrate; and
obtaining the chitosan-based substrate.

Clause 24. The method according to clause 23,

wherein the degree of acetylation is the percentage of the number of acetylated units over the total number of units forming the chitosan; and
wherein the acetylated units are N-acetylglucosamine units and the units forming the chitosan comprise N-acetylglucosamine units and glucosamine units.

Clause 25. The method according to clause 23 or claim 24, wherein the weight average molecular weight is between 1200 kDa and 1700 kDa, specifically the weight average molecular weight is about 1500 kDa.

Clause 26. The method according to any of clauses 23 to 25, the method comprising, after obtaining the chitosan-based substrate, heating the chitosan-based substrate until the chitosan-based substrate comprises a moisture content equal to or less than 4%.

Clause 27. The method according to any of clauses 23 to 25, the method comprising, after obtaining the chitosan-based substrate, heating the chitosan-based substrate until the chitosan-based substrate comprises a moisture content equal to or less than 1%.

Clause 28. The method according to clause 26 or clause 27, wherein heating the chitosan-based substrate comprises heating the chitosan-based substrate at a temperature greater than a boiling point of any substance forming the acidic solution, specifically the temperature is equal to or greater than 150°C.

Clause 29. The method according to any of clauses 26 to 28, the method comprising, after heating the chitosan-based substrate, delivering a conductive agent composition onto the chitosan-based substrate to form a conductive element configured to:

- act as an antenna of an RFID tag; or
- act as a galvanic connection between an RFID circuitry of the RFID tag and the antenna of the RFID tag; or
- act as an inductive element to inductively couple the RFID circuitry to the antenna of the RFID tag.

Clause 30. The method according to clause 29, the method comprising, after delivering the conductive agent composition, curing the conductive agent composition.

Clause 31. Use of chitosan as a substrate for flexible electronics, the chitosan with a weight average molecular weight between 1000 kDa and 1700 kDa and a degree of acetylation equal to or less than 10%;

wherein the degree of acetylation is the percentage of the number of acetylated units over the total number of units forming the chitosan; and
wherein the substrate comprises a moisture content equal to or less than 4%.

Clause 32. Use of the chitosan of clause 31, wherein the chitosan comprises a moisture content equal to or less than 1%.

Clause 33. The use according to clause 31 or clause 32, wherein the substrate is for use to an RFID substrate.

Clause 34. An integrated circuit for a radio frequency identification, RFID, tag, the integrated circuit comprising:

- RFID circuitry,
- an antenna coupled or connected to the RFID circuity;
- either a galvanic connection between the RFID circuitry and the antenna or an inductive element to inductively couple the RFID circuitry to the antenna; and
- a chitosan-based substrate according to clauses 18 to 22;

wherein the RFID circuity, either the galvanic connection or the inductive element, and the antenna are supported by the chitosan-based substrate according to clauses 18 to 22.

Although only a number of examples have been disclosed herein, other alternatives, modifications, uses and/or equivalents thereof are possible. Furthermore, all possible combinations of the described examples are also covered. Thus, the scope of the present disclosure should not be limited by particular examples, but should be determined only by a fair reading of the claims that follow. If reference signs related to drawings are placed in parentheses in a claim, they are solely for attempting to increase the intelligibility of the claim, and shall not be construed as limiting the scope of the claim.

## Claims

**1.** A chitosan-based substrate for flexible electronics, the chitosan-based substrate comprising:

chitosan with a weight average molecular weight between 1000 kDa and 1700 kDa and a degree of acetylation equal to or less than 10%;
wherein the degree of acetylation is the percentage of the number of acetylated units over the total number of units forming the chitosan; and
wherein the chitosan-based substrate comprises a moisture content equal to or less than 4%.

**2.** The chitosan-based substrate according to claim 1, wherein the chitosan-based substrate comprises a moisture content equal to or less than 1%.

**3.** The chitosan-based substrate according to claim 1 or claim 2, wherein the acetylated units are N-acetylglucosamine units and the units forming the chitosan comprise N-acetylglucosamine units and glucosamine units.

**4.** The chitosan-based substrate according to any of claims 1 to 3, wherein the weight average molecular weight is between 1200 kDa and 1700 kDa.

**5.** The method according to claim 4, wherein the weight average molecular weight is about 1500 kDa.

**6.** Method for manufacturing a chitosan-based substrate for flexible electronics, the method comprising:

providing chitosan with a weight average molecular weight between 1000 kDa and 1700 kDa and a degree of acetylation equal to or less than 10%;
adding the chitosan to an acidic solution;
depositing the acidic solution comprising the chitosan to form the chitosan-based substrate;
obtaining the chitosan-based substrate; and
heating the chitosan-based substrate until the chitosan-based substrate comprises a moisture content equal to or less than 4%.

**7.** The method according to claim 6,

wherein the degree of acetylation is the percentage of the number of acetylated units over the total number of units forming the chitosan; and
wherein the acetylated units are N-acetylglucosamine units and the units forming the chitosan comprise N-acetylglucosamine units and glucosamine units.

**8.** The method according to claim 6 or claim 7, wherein the weight average molecular weight is between 1200 kDa and 1700 kDa, specifically the weight average molecular weight is about 1500 kDa.

**9.** The method according to any of claims 1 to 8, the method comprising, after obtaining the chitosan-based substrate,

heating the chitosan-based substrate until the chitosan-based substrate comprises a moisture content equal to or less than 1%.

**10.** The method according to any of claims 1 to 9, wherein heating the chitosan-based substrate comprises heating the chitosan-based substrate at a temperature greater than a boiling point of any substance forming the acidic solution.

**11.** The method according to claim 10, wherein heating the chitosan-based substrate comprises heating the chitosan-based substrate at the temperature equal to or greater than 150°C.

**12.** The method according to any of claims 1 to 11, the method comprising, after heating the chitosan-based substrate, delivering a conductive agent composition onto the chitosan-based substrate to form a conductive element configured to:

- act as an antenna of an RFID tag; or
- act as a galvanic connection between an RFID circuitry of the RFID tag and the antenna of the RFID tag; or
- act as an inductive element to inductively couple the RFID circuitry to the antenna of the RFID tag.

**13.** The method according to claim 12, the method comprising, after delivering the conductive agent composition, curing the conductive agent composition.

**14.** Use of chitosan as a substrate for flexible electronics, the chitosan with a weight average molecular weight between 1000 kDa and 1700 kDa and a degree of acetylation equal to or less than 10%;

wherein the degree of acetylation is the percentage of the number of acetylated units over the total number of units forming the chitosan; and
wherein the substrate comprises a moisture content equal to or less than 4%.

**15.** An integrated circuit for a radio frequency identification, RFID, tag, the integrated circuit comprising:

- RFID circuitry,
- an antenna coupled or connected to the RFID circuity;
- either a galvanic connection between the RFID circuitry and the antenna or an inductive element to inductively couple the RFID circuitry to the antenna; and
- a chitosan-based substrate according to claims 1 to 5;

wherein the RFID circuity, either the galvanic connection or the inductive element, and the antenna are supported by the chitosan-based substrate.

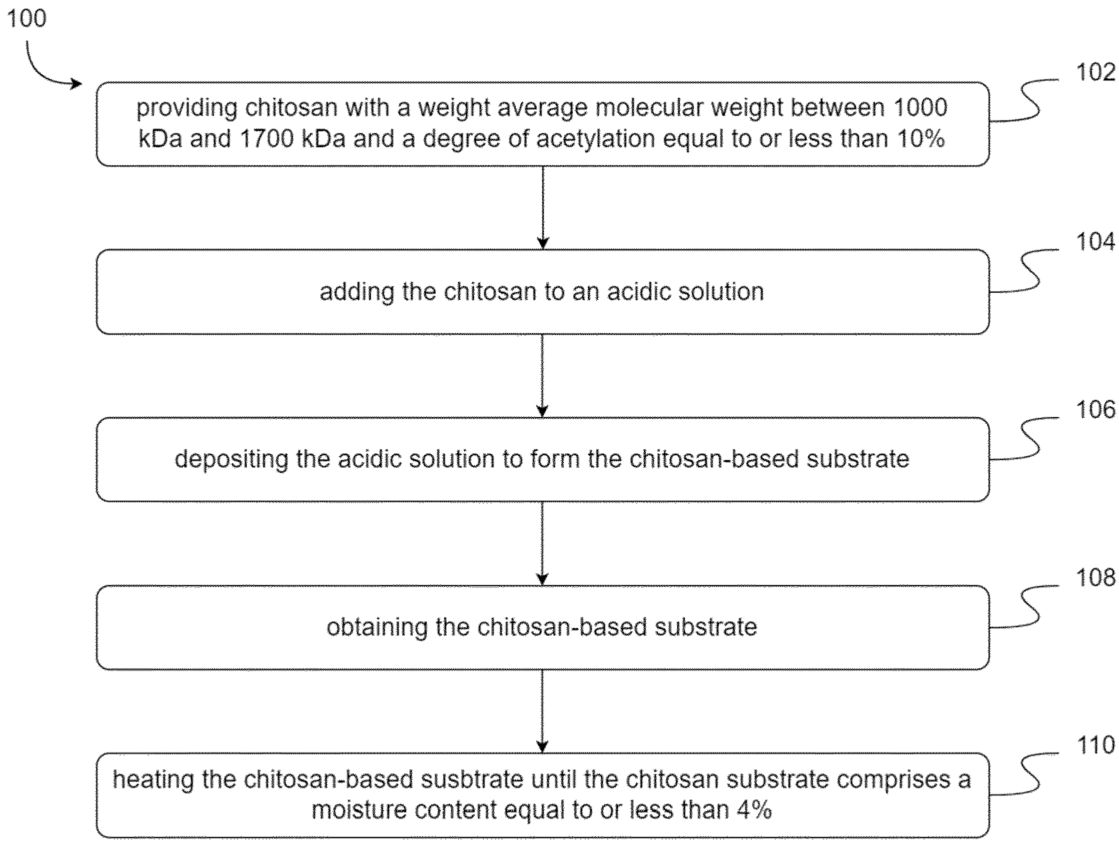
100
providing chitosan with a weight average molecular weight between 1000 kDa and 1700 kDa and a degree of acetylation equal to or less than 10%
102
adding the chitosan to an acidic solution
104
depositing the acidic solution to form the chitosan-based substrate
106
obtaining the chitosan-based substrate
108
heating the chitosan-based susbtrate until the chitosan substrate comprises a moisture content equal to or less than 4%
110

Fig. 1

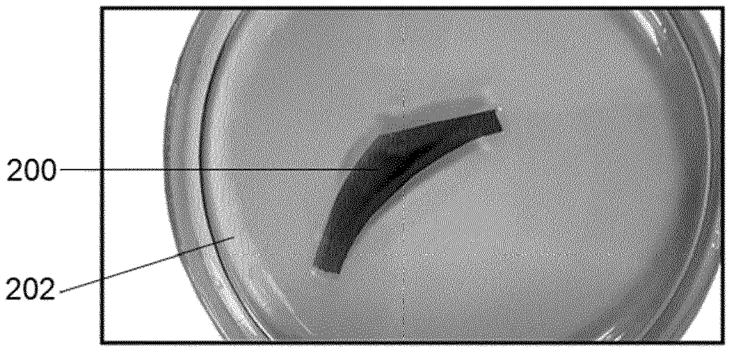


Fig. 2a

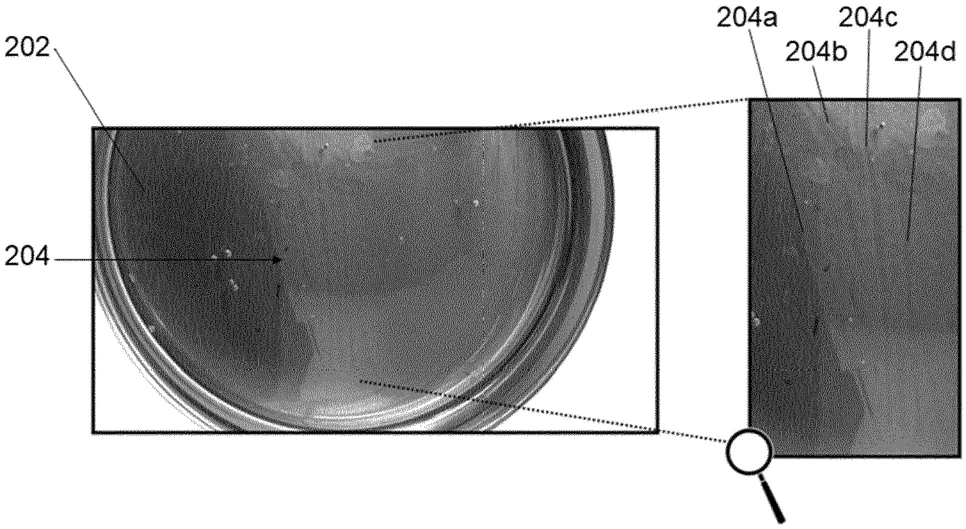


Fig. 2b

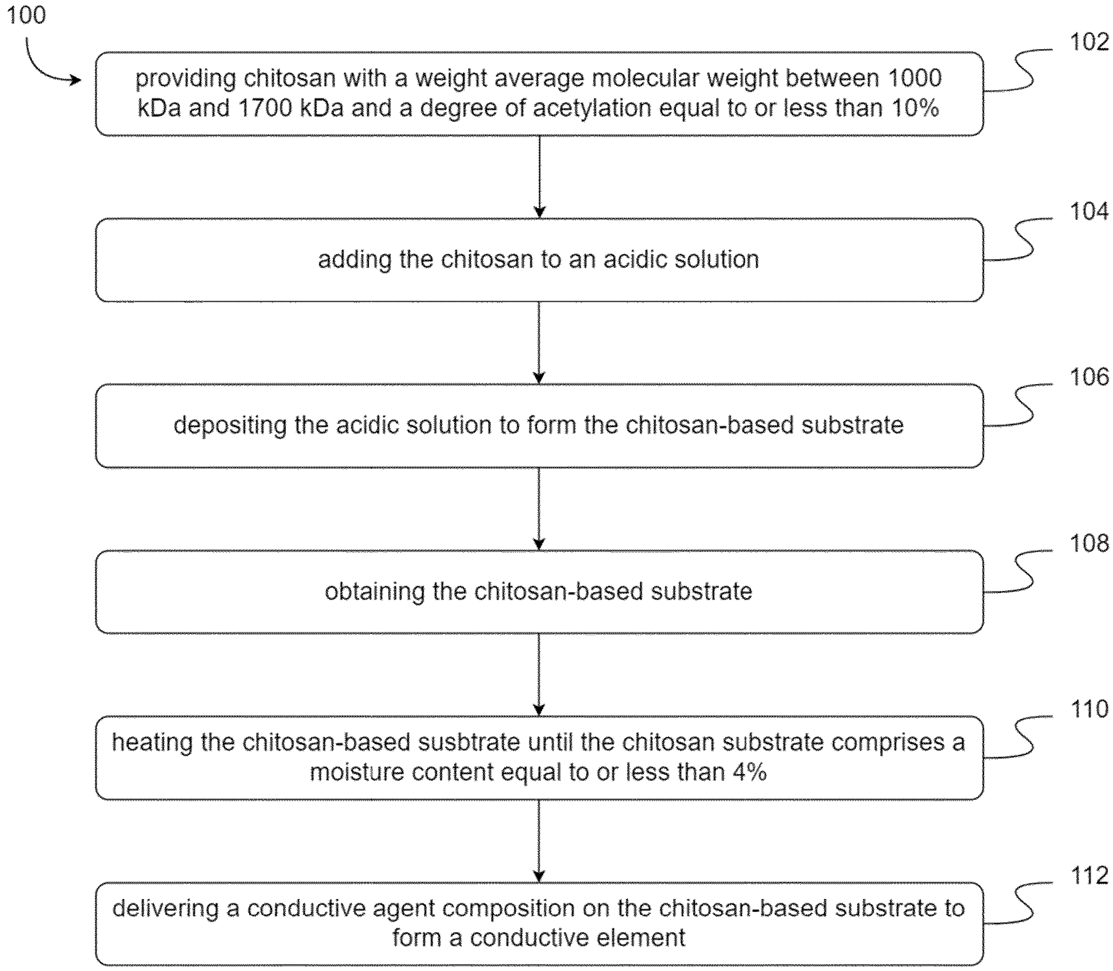
100
102
providing chitosan with a weight average molecular weight between 1000 kDa and 1700 kDa and a degree of acetylation equal to or less than 10%
104
adding the chitosan to an acidic solution
106
depositing the acidic solution to form the chitosan-based substrate
108
obtaining the chitosan-based substrate
110
heating the chitosan-based susbstrate until the chitosan substrate comprises a moisture content equal to or less than 4%
112
delivering a conductive agent composition on the chitosan-based substrate to form a conductive element

Fig. 3

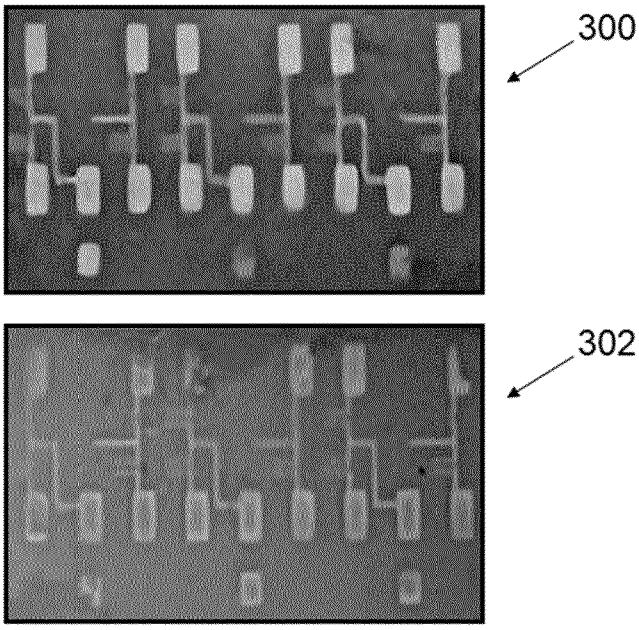


Fig. 4

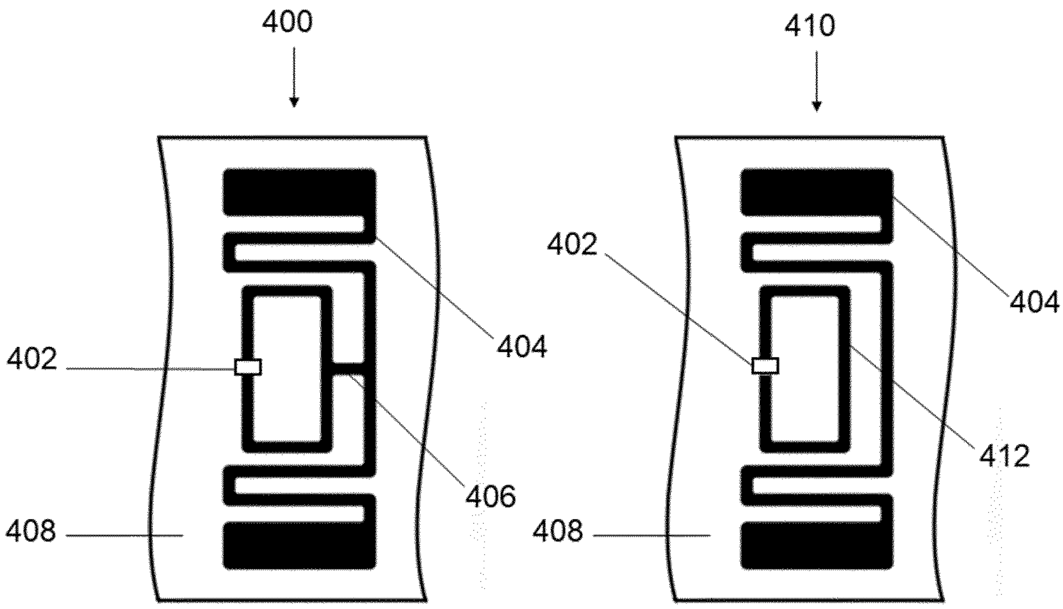


Fig. 5

Europäisches Patentamt
European Patent Office
Office européen des brevets

# EUROPEAN SEARCH REPORT

Application Number
EP 24 38 2925

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | AFFES SAWSAN ET AL: "Controlled size green synthesis of bioactive silver nanoparticles assisted by chitosan and its derivatives and their application in biofilm preparation", CARBOHYDRATE POLYMERS, APPLIED SCIENCE PUBLISHERS , LTD BARKING, GB, vol. 236, 24 February 2020 (2020-02-24), XP086086214, ISSN: 0144-8617, DOI: 10.1016/J.CARBPOL.2020.116063 [retrieved on 2020-02-24] | 1-10 | INV. C08J3/05 C08J5/18 C08L5/08 H05K1/03 |
| A | * abstract * * paragraphs [002.], [2.4.2.2.] * * table 1 * ----- | 11-15 | |
| X | RAMADHAN ZENO RIZQI ET AL: "Surface-functionalized silver nanowires on chitosan biopolymers for highly robust and stretchable transparent conducting films", MATERIALS RESEARCH LETTERS., [Online] vol. 7, no. 3, 6 January 2019 (2019-01-06) , pages 124-130, XP093247638, ISSN: 2166-3831, DOI: 10.1080/21663831.2018.1563837 Retrieved from the Internet: URL:https://www.tandfonline.com/doi/pdf/10.1080/21663831.2018.1563837> [retrieved on 2025-02-07] | 1-14 | TECHNICAL FIELDS SEARCHED (IPC) H05K C08J C08L |
| Y | * abstract * * paragraph [002.]; figure 1 * ----- -/-- | 15 | |

The present search report has been drawn up for all claims

| Place of search | Date of completion of the search | Examiner |
|---|---|---|
| Munich | 9 February 2025 | Lartigue, M |

1

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

page 1 of 2

Europäisches Patentamt
European Patent Office
Office européen des brevets

# EUROPEAN SEARCH REPORT

Application Number
EP 24 38 2925

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | S. T. KOEV ET AL: "Chitosan: an integrative biomaterial for lab-on-a-chip devices", LAB ON A CHIP, vol. 10, no. 22, 1 November 2010 (2010-11-01), pages 3026-3042, XP055047231, ISSN: 1473-0197, DOI: 10.1039/c0lc00047g * abstract * * paragraphs [003.], [3.1.] * ----- | 1-15 | |
| A | WO 2024/036404 A1 (9418 3712 QUEBEC INC [CA]) 22 February 2024 (2024-02-22) * paragraph [0028] * ----- | 1-15 | |
| Y | US 11 938 708 B1 (UZ METIN [US] ET AL) 26 March 2024 (2024-03-26) * column 1, lines 20-29 * * column 8, lines 5-19, 57-67 * ----- | 15 | |

TECHNICAL FIELDS SEARCHED (IPC)

1

The present search report has been drawn up for all claims

| Place of search | Date of completion of the search | Examiner |
|---|---|---|
| Munich | 9 February 2025 | Lartigue, M |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT ON EUROPEAN PATENT APPLICATION NO.

EP 24 38 2925

This annex lists the patent family members relating to the patent documents cited in the above-mentioned European search report. The members are as contained in the European Patent Office EDP file on
The European Patent Office is in no way liable for these particulars which are merely given for the purpose of information.

09-02-2025

| Patent document cited in search report | Publication date | Patent family member(s) | Publication date |
|---|---|---|---|
| WO 2024036404 A1 | 22-02-2024 | NONE | |
| US 11938708 B1 | 26-03-2024 | US 11465397 B1 | 11-10-2022 |
| | | US 11938708 B1 | 26-03-2024 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Non-patent literature cited in the description

- *CHEMICAL ABSTRACTS*, 9012-76-4
- *CHEMICAL ABSTRACTS*, 56-81-5
- *CHEMICAL ABSTRACTS*, 64-17-5
- *CHEMICAL ABSTRACTS*, 67-63-0
- *CHEMICAL ABSTRACTS*, 64-19-7
- *CHEMICAL ABSTRACTS*, 7732-18-5